(19) Europäisches Patentamt
European Patent Office
Office européen des brevets

(11) **EP 4 383 991 A1**

(12) **EUROPEAN PATENT APPLICATION**

(43) Date of publication:
**12.06.2024 Bulletin 2024/24**

(21) Application number: **22211915.8**

(22) Date of filing: **07.12.2022**

(51) International Patent Classification (IPC):
**H10N 10/852** (2023.01)  **H10N 15/00** (2023.01)

(52) Cooperative Patent Classification (CPC):
**H10N 10/852; H10N 15/00**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Max-Planck-Gesellschaft zur Förderung der Wissenschaften e.V.**
**80539 München (DE)**

(72) Inventors:
• **Felser, Claudia**
  **06118 Halle (DE)**
• **He, Bin**
  **01187 Dresden (DE)**
• **Pan, Yu**
  **01187 Dresden (DE)**

(74) Representative: **Schweitzer, Klaus et al**
**Plate Schweitzer Zounek**
**Patentanwälte**
**Rheingaustrasse 196**
**65203 Wiesbaden (DE)**

(54) **MAGNETO THERMOELECTRIC MATERIAL**

(57)  The present invention pertains to a thermoelectric material which exhibits a ZT of $\geq 0.3$ and which is exposed to an external magnetic field of 0.01T - 2T resulting in a ZT of $\geq 1.3$ at a temperature of $\leq 300K$. More specifically the present invention pertains to thermoelectric materials at a temperature of $\leq 300K$ under an applied external magnetic field of 0.01T - 2T, wherein the material comprises:
- a three-dimensional topological insulator, or topological semimetal
- having a carrier mobility of $\geq 10^4$ cm$^2$/Vs at 20 K and
- a carrier concentration of $10^{17}$-$10^{20}$/cm$^3$, and
- an effective mass $\leq 0.04$ free electron mass, and
- a Fermi energy of $\leq 100meV$.

The invention further relates to a method of making a thermoelectric material which exhibits a ZT value of $\geq 1.3$ at a temperature of $\leq 300K$, and which is achieved at a low magnetic field of less than 2 T.

Figure 4

EP 4 383 991 A1

**Description**

**FIELD OF THE INVENTION**

The present invention pertains to the technical field of topological magneto thermoelectric material. More particularly, the present invention pertains to the enhanced thermoelectric performance of topological insulators or topological semimetals in the presence of a magnetic field.

**BACKGROUND**

Thermoelectric technology is able to convert heat into electricity, or vice versa. Unlike the well-established high temperature waste heat recovery, very few materials show promising low temperature cooling performance due to a small Seebeck coefficient, because the Seebeck coefficient in good thermoelectric materials scales with temperature.

The Seebeck effect describes the generation of a thermoelectric voltage along a temperature gradient when a temperature gradient is applied to a sample. The Seebeck coefficient is defined as the inverse of the voltage generated divided by the temperature difference, i.e. $S = -\Delta V/\Delta T$. The Seebeck coefficient, along with electrical conductivity and thermal conductivity, is the key factor for high performance thermoelectric material.

Generally, the Seebeck coefficient is proportional to the density of state effective mass ($m^*_d$, where

$$m^*_d = g^{2/3}m^*$$

, m* being the band effective mass and g being the degeneracy) and inversely proportional to the carrier concentration ($n^{2/3}$) in a given system. To date, an effective approach to for good thermoelectric performance is to have a high degeneracy (g) of small mass bands (m*), which can maintain both a high Seebeck coefficient and a high electrical conductivity

One material under consideration for thermoelectric device applications is bismuth. Bismuth is a weak topological insulator in a "hinge state" (Aggarwal, L. et al. Nat Commun 12, 4420 (2021)). By alloying bismuth with e.g. antimony, the resulting Bi-Sb alloy can become a semimetal or remain an insulator, depending on the Bi:Sb ratio (R. Wolfe, G.E. Smith, Appl. Phys. Lett. 1, 5 (1962)).

Bismuth tellurides and its solid solutions such as $(Bi-Sb)_2Te_3$ and $Bi_2(Te-Se)_3$ are good topological insulators [Chen, Y. L. et al. Science 5937, 178-181 (2009)] as well as good thermoelectric materials at room temperature [Heremans, J., Cava, R. & Samarth, N. Nat. Rev. Mater. 2, 17049 (2017)] and therefore suitable for refrigeration applications around 300 K.

PbTe is an inverted band semiconductor with a band gap of ~ 0.2 eV. Pure PbTe can be optimized via thallium-doping, which achieves a ZT of 1.5 at 773 K. [Heremans, J. P. et al. Science 321, 5888, 554-557 (2008)]. By further alloying with SnTe, another topological insulator, the $Pb_{1-x}Sn_xTe$ system is generated, which is known as a massive Dirac semimetal with high mobility (>110000 $cm^2$/Vs at 5 K) [Liang, T et al. Nat Commun 4, 2696 (2013)].

HgTe is a topological semimetal with very small effective mass (0.02 ~ 0.03 free electron mass) and an ultra-high mobility of >$10^6$ $cm^2$/Vs when grown by MBE (Molecular Beam Epitaxy). By further alloying with CdTe, it can be tuned as a quantum spin Hall insulator. [König, M. et al. Science 318. 5851 766-770 (2007)].

$Cd_3As_2$ is known as a 3D Dirac semimetal with ultrahigh mobility (>$10^7$ $cm^2$/Vs) a carrier concentration of at best 3.3•$10^{18}$/$cm^3$, a free electron mass of more than 0.04 free electron mass, a fermi Energy of more than 46 meV and giant magnetoresistance at low temperatures [Liang, T. et al. Nature Mater 14, 280-284 (2015), H. Wang et al. Magnetic Field-Enhanced Dirac Semimetal Concentrations, Adv. Funct. Mater. 2019, 29, 1902437]. Meanwhile, the magnetic field response of the thermoelectric properties has also been reported, which can saturate below 2 T [Liang, T et al. Phys. Rev. Lett. 118, 136601 (2017)]. A thermoelectric figure of merit (ZT) of greater than 1 at 375 K has been reported in a magnetic field.

$ZrTe_5$ is a Dirac semimetal with a Lifschiz transition around 100 K. It is known as the only 3D quantum Hall system, with a mobility of >$5\times10^5$ $cm^2$/Vs at 2 K [Tang. F, et al. Nature 569, 537-541 (2019)]. A decent field response can be achieved well below 2 T, in both electrical and thermoelectric transport properties [Galeski, S., et al. Nat Commun 12, 3197 (2021)]. The best thermoelectric performance can be expected around 100 K.

$WTe_2$ is known as a type II Weyl semimetal with a perfect compensation between the electrons and holes [Ali, M. et al Nature 514, 205-208 (2014)]. $WTe_2$ is the first reported giant magnetoresistance system due to its high mobility of electrons and holes. It also shows giant Nernst signal and magneto-Seebeck signal [Pan, Y. et al. Nat Commun 13, 3909 (2022)].

**OBJECT OF THE INVENTION**

It was an object of the present invention to provide thermoelectric materials with an improved thermoelectric property - compared to known thermoelectric materials, especially at temperatures of ≤300K. It was a specific object to improve the thermoelectric properties of topological thermoelectric materials, which already exhibit a ZT of ≤0.3 at temperatures of ≤300K. As an even more challenging object thermoelectric compounds should be provided which

- exhibit a ZT value of ≥ 1.3

- in a magnetic field of below 2 T

- at temperatures of ≤5300K.

## BRIEF DESCRIPTION OF THE INVENTION

The present inventors have found that the thermoelectric properties of known thermoelectric compounds, specifically those, which already possess a ZT of ≥ 0.3 can be increased to ≥ 1.3 at temperatures around or below room temperature, i.e. at temperatures of ≤300K, preferably ≤290K, even more preferred ≤280K, by exposing these thermoelectric compounds to an external magnetic field. It was surprising that even the application of a low magnetic field in the range of 0.01T - 2T yielded in this impressive increase in ZT.

In a preferred embodiment, the thermoelectric properties of topological materials are improved. Topology refers to a relativistic effect in heavy element compounds. Due to the dispersion of the electronic bands, the outer shell of the heavy elements may have a lower energy than the inner shell of the light elements (for instance Bi 6p band vs the Se 4p band in $Bi_2Se_3$). In this case, a band inversion can be created, which can result in a change in properties, for instance, the conductance quantum or the Berry curvature, which can be describe with integers. Common topological materials are topological insulators and topological semimetals, both of which have been reported to have surface states, small effective masses, high mobility and strong field response of their transport properties. Therefore, the unique band signature of topological materials provides an ideal platform for improved thermoelectric materials. The band inversions in topological systems not only generate the topological integers, but also modify the electronic structure of the topological material. With the band inversion, the conduction band minima and the valence band maxima are shifted from high symmetry points to lower symmetry points, which can generate a higher degeneracy. At the same time, the sharp E-k dispersion at the crossing of two bands gives rise to pockets with small band mass and high mobility, which is most pronounced in topological semimetals, like Dirac and Weyl semimetals. Such high mobility electrons can show a strong response to an external magnetic field making topological insulators and topological semimetals ideal candidates for magneto-thermoelectric materials.

As a consequence of the above the present inventors have found that specifically in three-dimensional topological insulators or topological semimetals, the Seebeck coefficient can be enhanced by an applied magnetic field, while at the same time, the electrical and thermal conductivities are reduced. This leads to an impressive enhancement in the thermoelectric figure of merit ZT.

As mentioned above, the band inversion in topological insulators and topological semimetals can generate a high-degeneracy, low effective mass pockets with low carrier concentrations, which then results in a low Seebeck coefficient. In a semi-classic picture, by applying an external magnetic field, an enhancement can be achieved in the topological semimetallinsulators, with the Seebeck coefficient increasing under the applied magnetic field at low field strengths ($\mu B < 1$, $\mu$ is the mobility and B is the applied field) and saturating at high field strengths ($\mu B \gg 1$). The electrical resistivity increases with the applied field, which means that the electrical conductivity decreases with applied field ($\sigma = 1/\rho$), and by Wiedemann-Franz Law, the thermal conductivity should also decrease with the applied field. The figure of merit $ZT$ can be calculated by the formula $ZT = S^2T/\rho\kappa$, where $S$ is the Seebeck coefficient, $\rho$ is the resistivity, $\kappa$ is the thermal conductivity and T is absolute temperature. As long as the gain in Seebeck term $S^2$ is greater than the increase in resistivity term $\rho$, a finite enhancement is achieved in $ZT$.

Based on the above findings it was hypothesized and confirmed that the thermoelectric properties of known thermoelectric compounds, specifically those which already possess a ZT of ≥0.3, can be increased to ≥1.3 at or even below room temperature, by exposing these thermoelectric compounds to an external magnetic field which can be as low as 0.01T - 2T; these improved thermoelectric compounds are called magneto thermoelectric compounds.

More specifically, the application of the above theoretical principals yielded in the finding that ideal candidates for improved thermoelectric materials are three-dimensional topological insulators, or topological semimetals, with high carrier mobilities, which can benefit from a larger gain in the magneto-Seebeck coefficient. Additionally, proper doping of these candidates can yield in an improved thermoelectric performance of up to 150% compared to the same topological insulator, or topological semimetal without doping.

Preferred candidates for three-dimensional topological insulators or topological semimetals which meet the above requirements are alloys or compounds selected from all the topological insulators or topological semimetals, including but not limited to:

- Bi-Sb alloys, $Bi_2Te_3$, $Bi_2Se_3$, HgTe, SnTe, PbTe, $Cd_3As_2$, $WTe_2$ and $ZrTe_5$.

By doping a trace amount of either a p- or n-type dopant into these topological insulators/semimetals, the position of the Fermi energy can effectively be shifted towards the conduction band/valence band towards the optimum carrier concentration of good thermoelectric materials. The best thermoelectric performance at or even below room temperature can be achieved by applying a magnetic field to the best zero-field performance crystal, with an applied field strength of 0.01T-2 T.

**BRIEF DESCRIPTION OF THE DRAWINGS**

The accompanying drawings are included to provide a more detailed understanding of the invention. The drawings illustrate exemplary embodiments of the present invention and, together with the description, serve to explain the principles of the present invention.

Figure 1 shows the evident enhancement of the Seebeck coefficient in topological materials; the selected systems $Bi_2Te_3$ and Bi-Sb alloy are taken as examples.

Figure 2 shows the magnetic field dependence of the thermoelectric transport properties of Te-doped $Bi_{0.88}Sb_{0.12}$ alloy from 0 to 2 T within the temperature range of 20 K to 300 K.

Figure 3 shows the Hall response of Te-doped $Bi_{0.88}Sb_{0.12}$ alloy from 20 K to 300 K, with the resolved carrier concentration and mobility.

Figure 4 shows the field dependence of ZT in Te-doped $Bi_{0.88}Sb_{0.12}$ alloy, with the temperature dependent peak ZT.

**DETAILED DESCRIPTION OF THE INVENTION**

The present invention provides topological magneto thermoelectric compounds which are thermoelectric compounds which exhibit a ZT of $\geq 0.3$ at temperatures of $\leq 300K$, preferably $\leq 290K$, even more preferred $\leq 280K$ and which are exposed to an external magnetic field of 0.01T - 2T, preferably 0.01T - 1T, more preferred 0.01T - 0.5T resulting in a ZT of ?1.3, preferred ZT>1.7 and more preferred ZT>2.0

More specifically, the present invention provides a thermoelectric material comprising:

- a three-dimensional topological insulator, or topological semimetal

- having a carrier mobility of $\geq 10^4$ $cm^2/Vs$, preferably $\geq 5 \times 10^4$ $cm^2/Vs$, more preferred $\geq 10^5$ $cm^2/Vs$ (at 20 K) and

- a carrier concentration of $10^{17}$-$10^{20}/cm^3$, and

- a small effective mass of $\leq 0.04$ preferably $\leq 0.02$, more preferred $\leq 0.01$ free electron mass, and

- a Fermi energy of $\leq 100meV$, preferably $\leq 50$ meV, more preferred $\leq 30$ meV.

with Seebeck enhancement under an applied external magnetic field of 0.01T - 2T, preferably 0.01 T - 1T, more preferred 0.01 T - 0.5T at temperatures of $\leq 300K$, preferably $\leq 290K$, even more preferred $\leq 280K$. The lower limit of 0.01 T is chosen in order to indicate that the applied external magnetic field is meant to be larger than the (natural) magnetic field of the earth, which is about 25-65 $\mu T$. Thus, in order to clearly distinguish from the magnetic field of the earth, the minimum applied external magnetic field is set to $\geq 0.01$ T.

In order to find three-dimensional topological insulators or topological semi-metals which match the present basic criteria for candidates for improved thermoelectric materials, for example, the Inorganic Crystal Structure Database, FIZ Karlsruhe (ICSD; https://icsd.fiz-karisruhe.de), eventually in combination with the Bilbao Crystallographic Server (http://www.cryst.ehu.es/) can serve as a source.

The ICSD is a chemical database which seeks to contain information on all inorganic crystal structures published since 1913, including pure elements, minerals, metals, and intermetallic compounds (with atomic coordinates). The ICSD contains over 270,000 entries as of October 2022 and is updated twice a year.

The Bilbao Crystallographic Server is an open access website offering online crystallographic database and programs aimed at analyzing, calculating and visualizing problems of structural and mathematical crystallography, solid state physics and structural chemistry. Of specific interest are the "TQC" (Topological Quantum Chemistry) pages on the Bilbao Crystallographic Server, which can provide Band Representations for Space Groups.

E.g. with the aid of the above data bases one selects topological insulators or topological semimetals which already come close to the target properties:

- a carrier mobility of $\geq 10^4$ cm$^2$/Vs, preferably $\geq 5 \times 10^4$ cm$^2$/Vs, more preferred $\geq 10^5$ cm$^2$/Vs (at 20 K) and

- a carrier concentration of $10^{17}$-$10^{20}$/cm$^3$, and

- a small effective mass of $\leq 0.04$ preferably $\leq 0.02$, more preferred $\leq 0.01$ free electron mass, and

- a Fermi energy of $\leq 100$meV, preferably $\leq 50$ meV, more preferred $\leq 30$ meV.

The reason for starting with a topological insulator or a topological semimetal is because in topological materials, there always exist band inversions. These inverted bands can result in very small effective masses, high degeneracy, and high mobility. On the other hand, in non-topological materials the bands are generally heavier than topological materials, so that such heavy bands have lower mobilities and weaker field response. Materials with an intrinsically small band effective mass but high mobilities, even non-topological materials, can still be within the scope of this invention.

In order to further approach the above desired target properties, the preselection of topological insulators or topological semimetals can be further refined by making the topological band more pronounced as well as by doping. The former can be achieved by providing an alloy. For instance, by adding Sb to Bi, or by adding SnTe to PbTe, or by adding $Bi_2Se_3$ to $Bi_2Te_3$. Taking the Bi-Sb system as an example, pure Bi is a semimetal with electron and hole concentrations of $3 \times 10^{17}$/cm$^3$. After alloying with Sb, the Bi-Sb system becomes a topological insulator, which fits in the prerequisite of this invention. Similarly, PbTe is an invert-band semiconductor with a large effective mass of 0.2 free electron mass. By adding SnTe, it turns into a topological crystalline insulator with a mobility of over 110,000 cm$^2$/Vs at 5 K and ~ 80,000 cm$^2$/Vs at 20 K. With the achieved status of a topological semimetal/insulator, one can further tune the properties via doping. For example, the use of Te for doping Bi, results in one excess electron per dopant. This shows that one can precisely control the carrier concentration of a topological insulator/semimetal, tune the carrier concentration to the optimum value (which is material dependent), and acquire the best thermoelectric performance when an external field is applied in order to push the topological insulator/semimetal to its best figure of merit.

Bi-Sb alloy has been used here as a non-limiting example for demonstrating the principles of the invention. Bi is reported to have an effective mass of 0.001 free electron mass and exhibiting a mobility of over $5 \times 10^6 cm^2/Vs$ at 20 K. Therefore, Bi alloys are amongst the preferred candidates for thermoelectric performance in magnetic field.

Application of the above described inventive principals can be applied to all topological insulators and topological semimetals, including but not limited to $Bi_2Te_3$, $Bi_2Se_3$, HgTe, SnTe, PbTe, $Cd_3As_2$, $WTe_2$ and $ZrTe_5$. One can always alloy two or more compounds together to achieve the desired band parameters and transport properties.

By properly doping either a p- or n-type dopant into the acquired topological insulators or topological semimetals, the position of the Fermi energy can effectively be shifted towards the conduction/valence band and a premium carrier density can be achieved, which then gives rise to the best thermoelectric performance.

Examples of tuning/doping topological insulators or topological semimetals selected from the above list are $Bi_2Te_3$ with $Sb_2Te_3$ (=p-type alloying), $Bi_2Te_3$ with $Bi_2Se_3$ (=n-type alloying), PbTe with SnTe (=p-type alloying), or Bi alloying with Sb and doping with Te (=n-type doped); i.e.,

| | |
|---|---|
| - $Bi_{2-x}Sb_xTe_3$ (x ~ 1.5) | p-type alloying |
| - $Bi_{1-x}Sb_x$ ($0 \leq x \leq 1$) + Te, | alloying and n-type doping |
| - $Bi_2Te_2Se$ | n-type alloying, or |
| - $Pb_{1-x}Sn_xTe$ ($0,2 \leq x \leq 0.4$) | p-type alloying |

For example, in $Bi_{1-x}Sb_x$ the dopant preferably is Te, which is preferably doped to the $Bi_{1-x}Sb_x$ alloy in a molar fraction of less than or equal to 0.01%, i.e., $Bi_{1-x}Sb_x$+yTe, y$\leq$0.01% (based on Bi).

Generation of thermoelectric properties in a magnetic field requires the application of a finite external magnetic field to the system. For practical application, the magnetic field should preferably be as low as possible, which on the other hand requires a high mobility of the electrons of the system, and therefore an ultra-low effective mass of the selected system. Surprisingly, the above topological insulators or topological semimetals can show already an enhanced Seebeck coefficient under the influence of an external magnetic field of only 0.01T - 2T (e.g. achievable with an electromagnet), preferably 0.01T - 1T (e.g. achievable with a rare-earth containing permanent magnet), more preferred 0.01T - 0.5T (e.g. achievable with a rare-earth free permanent magnet). The lower limit of the applied external magnetic field of 0.01 T is chosen in order to indicate that the applied external magnetic field is meant to be larger than the (natural) magnetic field of the earth, which is about 25-65 $\mu$T. Thus, in order to clearly distinguish from the magnetic field of the earth, the minimum applied external magnetic field is preferably $\geq$ 0.01 T.

In such an applied magnetic field, the Seebeck coefficient is significantly enhanced compared to the zero-field value, while the electrical resistivity does not increase by the same amount as the Seebeck coefficient squared. The thermal conductivity gradually reduces with the applied field; as a result, the thermoelectric performance is vastly boosted.

As mentioned above topological materials exhibit a band inversion and most likely also a band gap which may be subject to spin orbit coupling. Since spin orbit coupling is a relatively small perturbation in electronic structure, the energy gap is often very small, in the order of 100 meV. With such a small gap, the intrinsic excitation of both electrons and holes may be detrimental to the thermoelectric performance. Therefore, the topological materials are preferably restricted to thermoelectric applications at and below room temperature, i.e. to temperatures of $\leq$300K, preferably $\leq$290K, even more preferred $\leq$280K.

## METHOD OF MANUFACTURING

The thermoelectric material according to the present invention can be manufactured similar to conventional thermoelectric materials. For example, manufacturing of a module with a Bi-Sb alloy may start with growing a crystal, e.g. with the "horizontal travelling molten zone technique" using pre-molten mixtures of the elements (e.g. Bi and Sb) in the desired stoichiometric ratio as feed and seed crystals, then cutting the target crystal into small parallelepipeds which may then be connected as blocks in series. These blocks may then be placed between two slabs, e.g. made of ceramics, preferably with contacts prepared for the blocks to maintain a uniform temperature gradient. Doping can be achieved by simply adding the dopant to the initial alloy/compound mixture before starting the above described melting process.

## APPLICATIONS

The thermoelectric materials of the present invention can be used e.g. as or in refrigerators, called "thermoelectric coolers", or "Peltier coolers", or for power generation with a thermoelectric generator or in solar thermal energy generation.

## EXAMPLES

The invention is explained in more detail below with reference to examples of a Te doped single crystal of a $Bi_{0.88}Sb_{0.12}$ alloy with homogenous elemental distribution between 2 K - 300 K with an external magnetic field of 0 T - 2 T. Again, it needs to be emphasized that, the $Bi_{0.88}Sb_{0.12}$ is not the only example for such achievement. Any Bi-Sb alloys, semiconductive or semimetallic, will have a similar response, as long as the carrier concentration is in a reasonable range.

In the example, the crystal is grown with a horizontal travelling molten zone technique, using a $Bi_{0.97}Sb_{0.03}$ polycrystal as seed and a $Bi_{0.88}Sb_{0.12}$ polycrystal as feed. A traveling system with a motor and a heating coil is used for the travelling molten zone process. Both the seed and the feed polycrystals are prepared by melting stoichiometric Bi and Sb mixtures in a quartz ampoule at 700 °C followed by quenching. The obtained polycrystals are cylinders, which are transferred into a bigger ampoule. Careful control of the current applied to the heating coil confirms that only the seed is molten at the beginning of the crystal growth. The motor pushes the ampoule with crystals at a rate of 1mm/h in order to guarantee a good quality of the target crystal. The obtained grown crystal is loaded in a scanning electronic microscope for an Energy-dispersive X-ray spectroscopy test for the exact ratio of Bi vs Sb.

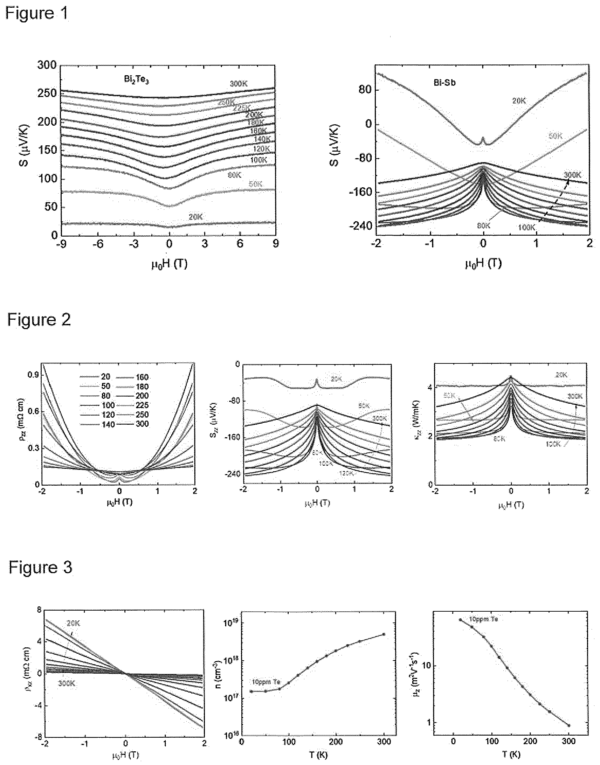

General example of field enhancement in the Seebeck coefficient of topological insulators/semiconductors is shown in Figure 1. $Bi_2Te_3$ and undoped Bi-Sb alloy are taken as examples to illustrate the effect of the magnetic field. Between the two, the Bi-Sb alloy has a strong field dependence, shown at a lower field. To better illustrate the invention, the Bi-Sb system is taken for further exhibition.

Field dependence of the resistivity $\rho$, Seebeck coefficient $S$, thermal conductivity $\kappa$ in the 10 ppm Te doped $Bi_{0.88}Sb_{0.12}$ alloy from 20 K to 300 K are shown in Figure 2. All three properties show strong field dependence in the entire temperature range. Particularly, below 100 K, global minima in resistivity are observed with a platform observed in the Seebeck coefficient. Meanwhile, the thermal conductivity decreases with field rapidly below 1 T saturates above 1 T.

The Hall resistivity at various temperatures up to 2 T are shown in Figure 3, along with resolved carrier concentration and averaged mobility. The Hall measurement is taken simultaneously with the thermoelectric transport properties on one sample. The Hall coefficient, which is the slope of the Hall resistivity versus magnetic field, gradually decreases with temperature, as a result of thermal excitation in insulators. The resolved carrier density is roughly $3 \times 10^{17}/cm^3$, much higher than the undoped topological insulator $Bi_{0.88}Sb_{0.12}$, showing the effectiveness of doping. The mobility at low temperature reaches 60 $m^2$/Vs, allowing a very strong response of all transport properties to the external field. The effective mass is at 0.008 free electron mass and the Fermi energy at 25 meV.

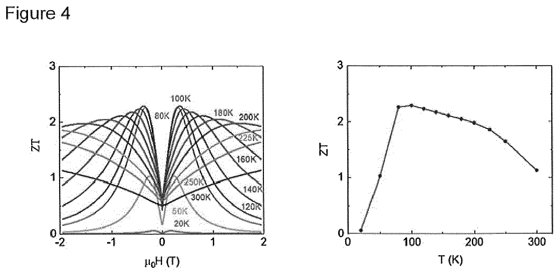

The field dependent ZT is shown in Figure 4. In the presence of an external magnetic field, between 80 K and 100 K, the highest ZT value reaches 2.3 at ~ 0.3 T. A high ZT of >2 can be achieved in a wide range of temperature, from 80 K to 200 K. For the high ZT at higher temperature, the optimum field gradually increases, from 0.3 T for 80 K to 1.5 T for 200 K. The thermoelectric parameter $ZT$ is calculated from $ZT=(S^2/\rho\kappa)T$, in which S, $\rho$, $\kappa$, $T$ are: Seebeck coefficient, resistivity, thermal conductivity, and temperature, respectively.

**Claims**

1. A thermoelectric material under an applied external magnetic field of 0.01T - 2 T at a temperature of $\leq$300K, wherein the material comprises:

   - a three-dimensional topological insulator, or topological semimetal
   - having a carrier mobility of $\geq 10^4$ cm$^2$/Vs at 20 K and
   - a carrier concentration of $10^{17}$-$10^{20}$/cm$^3$, and
   - an effective mass $\leq$ 0.04 free electron mass, and
   - a Fermi energy of $\leq$100 meV.

2. Thermoelectric material according to claim 1, wherein the thermoelectrical material is a three-dimensional topological

   - insulator or
   - semimetal,

   doped with a p- or n-type dopant.

3. Thermoelectric material according to claim 1 or 2, wherein the thermoelectrical material is a three-dimensional topological insulator or a three-dimensional topological semimetal selected from Bi-Sb alloys, Bi$_2$Te$_3$, Bi$_2$Se$_3$, PbTe, SnTe HgTe, Cd$_3$As$_2$, ZrTe$_5$ and WTe$_2$, or their alloys.

4. Thermoelectric material according to one of claims 1-3, wherein the thermoelectrical material is Bi$_{1-x}$Sb$_x$+yTe, y$\leq$0.01% (based on Bi).

5. A thermoelectric material which exhibits a ZT of $\geq$0.3 when and while it is not being exposed to a magnetic field of $\geq$0.01 T, wherein the material is at a temperature of $\leq$300K and under the influence of an external magnetic field of 0.01T - 2T, resulting in a ZT of $\geq$1.3.

6. Thermoelectric material according to one of claims 1-5, wherein the material is under the influence of an external magnetic field of 0.01 T - 1.0T, preferably 0.01T - 0.5T.

7. Method of making a thermoelectric material which exhibits a ZT value of $\geq$ 1.3, comprising the step of selecting a thermoelectric material, which possess a ZT of $\geq$0.3 when not being exposed to a magnetic field of $\geq$0.01 T, and then exposing this thermoelectric material to an external magnetic field of 0.01T - 2T at a temperature of $\leq$300K.

8. Method according to claim 7, wherein the thermoelectrical material is a three-dimensional topological

   - insulator or
   - semimetal,

   doped with a p- or n-type dopant.

9. Method according to claim 7 or 8, wherein the thermoelectrical material is a three-dimensional topological insulator or a three-dimensional topological semimetal selected from Bi-Sb alloys, Bi$_2$Te$_3$, Bi$_2$Se$_3$, PbTe, SnTe HgTe, Cd$_3$As$_2$, ZrTe$_5$ and WTe$_2$, or their alloys.

10. Method according to one of claims 7-9, wherein the thermoelectrical material is Bi$_{1-x}$Sb$_x$+yTe, y$\leq$0.01% (based on Bi).

11. Use of a thermoelectric material according to one of claims 1-6, as or in refrigerators.

**12.** Use of a thermoelectric material according to one of claims 1-6, for power generation with a thermoelectric generator.

**13.** Use of a thermoelectric material according to one of claims 1-6, in solar thermal energy generation.

**14.** Refrigerator comprising a thermoelectric material according to one of claims 1-6.

**15.** Power generator comprising a thermoelectric material according to one of claims 1-6.

**16.** Solar energy generator comprising a thermoelectric material according to one of claims 1-6.

Figure 1

Figure 2

Figure 3

Figure 4

**EUROPEAN SEARCH REPORT**

Application Number

EP 22 21 1915

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WANG HONGHUI ET AL: "Magnetic-field enhanced high-thermoelectric performance in topological Dirac semimetal Cd 3 As 2 crystal", SCIENCE BULLETIN, [Online] vol. 63, no. 7, 21 March 2018 (2018-03-21) , pages 411-418, XP093043204, CN ISSN: 2095-9273, DOI: 10.1016/j.scib.2018.03.010 Retrieved from the Internet: URL:https://www.sciencedirect.com/science/article/pii/S2095927318301257/pdfft?md5=5e80b81c59cc5079486e81fa14655ace&pid=1-s2.0-S2095927318301257-main.pdf> [retrieved on 2023-05-01] * the whole document * ----- | 1-16 | INV. H10N10/852 H10N15/00 |
| A | XIANG JUNSEN ET AL: "Large transverse thermoelectric figure of merit in a topological Dirac semimetal", SCIENCE CHINA PHYSICS, MECHANICS, SCIENCE CHINA PRESS, BEIJING, vol. 63, no. 3, 19 November 2019 (2019-11-19), XP037126759, ISSN: 1674-7348, DOI: 10.1007/S11433-019-1445-4 [retrieved on 2019-11-19] * the whole document * ----- | 1-16 | |
| | -/-- | | TECHNICAL FIELDS SEARCHED (IPC) H10N H02N |

The present search report has been drawn up for all claims

| Place of search | Date of completion of the search | Examiner |
|---|---|---|
| The Hague | 3 May 2023 | Kirkwood, Jonathan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | FU CHENGUANG ET AL: "Topological thermoelectrics", APL MATERIALS, AMERICAN INSTITUTE OF PHYSICS, 2 HUNTINGTON QUADRANGLE, MELVILLE, NY 11747, vol. 8, no. 4, 21 April 2020 (2020-04-21), XP012246305, DOI: 10.1063/5.0005481 [retrieved on 2020-04-21] * the whole document * | 1-16 | |
| A | US 2016/300992 A1 (RHYEE JONGSOO [KR] ET AL) 13 October 2016 (2016-10-13) * paragraph [0045] – paragraph [0057]; claims 1-9; figure 2 * | 1-16 | |

TECHNICAL FIELDS
SEARCHED      (IPC)

The present search report has been drawn up for all claims

| Place of search | Date of completion of the search | Examiner |
|---|---|---|
| The Hague | 3 May 2023 | Kirkwood, Jonathan |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 22 21 1915

This annex lists the patent family members relating to the patent documents cited in the above-mentioned European search report.
The members are as contained in the European Patent Office EDP file on
The European Patent Office is in no way liable for these particulars which are merely given for the purpose of information.

03-05-2023

| Patent document cited in search report | | Publication date | Patent family member(s) | | Publication date |
|---|---|---|---|---|---|
| US 2016300992 | A1 | 13-10-2016 | CN 105849923 | A | 10-08-2016 |
| | | | EP 3098862 | A1 | 30-11-2016 |
| | | | JP 6262862 | B2 | 17-01-2018 |
| | | | JP 2017510970 | A | 13-04-2017 |
| | | | KR 20150086627 | A | 29-07-2015 |
| | | | US 2016300992 | A1 | 13-10-2016 |
| | | | WO 2015108380 | A1 | 23-07-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **AGGARWAL, L. et al.** *Nat Commun,* 2021, vol. 12, 4420
- **R. WOLFE ; G.E. SMITH.** *Appl. Phys. Lett.,* 1962, vol. 1, 5
- **CHEN, Y. L. et al.** *Science,* 2009, vol. 5937, 178-181
- **HEREMANS, J. ; CAVA, R. ; SAMARTH, N.** *Nat. Rev. Mater.,* 2017, vol. 2, 17049
- **HEREMANS, J. P. et al.** *Science,* 2008, vol. 321 (5888), 554-557
- **LIANG, T et al.** *Nat Commun,* 2013, vol. 4, 2696
- **KÖNIG, M. et al.** *Science,* 2007, vol. 318 (5851), 766-770

- **LIANG, T. et al.** *Nature Mater,* 2015, vol. 14, 280-284
- **H. WANG et al.** Magnetic Field-Enhanced Dirac Semimetal Concentrations. *Adv. Funct. Mater.,* 2019, vol. 29, 1902437
- **LIANG, T et al.** *Phys. Rev. Lett.,* 2017, vol. 118, 136601
- **TANG. F et al.** *Nature,* 2019, vol. 569, 537-541
- **GALESKI, S. et al.** *Nat Commun,* 2021, vol. 12, 3197
- **ALI, M. et al.** *Nature,* 2014, vol. 514, 205-208
- **PAN, Y. et al.** *Nat Commun,* 2022, vol. 13, 3909